# EUROPÄISCHE PATENTSCHRIFT

(11) **EP 1 790 704 B1**
(45) Veröffentlichungstag und Bekanntmachung des Hinweises auf die Patenterteilung: **23.09.2009**
(21) Anmeldenummer: 07000326.4
(22) Anmeldetag: 06.08.2004
(51) Int. Cl.: C09J 5/06

(54) **Mikrosystembauelement und Verfahren zum Kleben von Mikrobauteilen auf ein Substrat**
micro system component and method for bonding micro components to a substrate
composant de microsystème et procédé destinés au collage de microcomposants sur un substrat

(30) Priorität: 25.08.2003 DE 10338967
(43) Veröffentlichungstag der Anmeldung: 30.05.2007
(62) Teilanmeldung aus: 04762615.5
(73) Patentinhaber: Technische Universität Braunschweig Carolo-Wilhelmina, 38106 Braunschweig (DE)
(72) Erfinder: Böhm, Stefan, 38179 Schwülper (DE); Stammen, Elisabeth, Dipl.-Chem., 52379 Langerwehe (DE); Pokar, Gero, 97332 Wolkach (DE); Dilger, Klaus, Prof. Dr.-Ing., 38106 Braunschweig (DE); Mund, Frank, Dipl.-Ing., 40223 Düsseldorf (DE); Wrege, Jan, 91056 Erlangen (DE)
(74) Vertreter: Kröncke, Rolf

(56) Entgegenhaltungen:
- WO-A-02/090454
- DE-A- 3 739 333
- DE-A- 19 819 054
- US-B1- 6 515 048

## Beschreibung

Die Erfindung betrifft ein Verfahren zum Kleben von Mikrobauteilen auf ein Substrat bei der Herstellung von Mikrosystembauelementen.

Die Erfindung betrifft weiterhin ein Mikrosystembauelement mit mindestens einem auf ein Substrat geklebtem Mikrobauteil.

In der Mikrosystemtechnik werden vielfach elektronische, elektromechanische oder rein mechanische Mikrobauteile auf ein Substrat geklebt. Die hierbei erforderliche Präzision, die geringen Klebflächen und die Notwendigkeit der Automatisierung des Fügevorgangs stellen hierbei ein besonderes Problem dar. Herkömmlicherweise erfolgt das Kleben von Mikrobauteilen mit viskosen Klebstoffen als Ein- oder Zwei-Komponentensysteme, die eine spezifische Topfzeit haben, innerhalb der die Klebeeigenschaften erhalten bleiben und der Klebvorgang durchgeführt werden kann. Viskose Klebstoffe haben zudem eine spezifische Aushärtezeit, die der Klebstoff benötigt, um eine stabile Klebverbindung zu gewährleisten.

In den Druckschriften US 6,126,765; US 2003/0029724 A1 und WO 98/45693 werden derartige Verfahren zum Verkleben von Mikrostrukturen mit viskosen Schmelzklebstoffen beschrieben.

Die Topfzeit sollte möglichst groß sein, um ein rationelles Fügen von Mikrobau-teilen durch großflächiges Auftragen des Klebstoffs auf das Substrat und an-schließendes Fügen einer Vielzahl von Mikrobauteilen auf das Substrat in einer für den Vorgang erforderlichen Zeit zu ermöglichen. Auf der anderen Seite sollte die Topfzeit und Aushärtezeit möglichst klein sein, damit die Klebverbindung nach dem Fügen sofort aushärtet und die Mikrobauteile sich nicht auf dem Substrat verschieben. Diese beiden konträren Randbedingungen sind kaum miteinander in Einklang zu bringen. Erschwerend hinzu kommt die in der Mikrosystemtechnik erforderliche geringe Schichtdicke des Klebstofffilms im µm-Bereich im Unterschied zur makroskopischen Klebung.

In der DE 198 50 041 A1 wird ein mikrotechnologisches Bondverfahren zur Herstellung einer Klebverbindung mit einem flüssigen oder pastösen Schmelzklebstoff beschrieben, der zumindest eine Viskosität derart aufweist, um als Kleberfaden mit einem definierten Querschnitt auf einem der Fügepartner plaziert zu werden. Die Klebewirkung entfaltet sich erst bei spezifischen äußeren Einwirkungen, beispielsweise Erwärmung des Klebstoffes, sodass der Kleberfaden aufgrund der noch nicht vorhandenen oder nur geringen Haftungstendenz verschoben werden kann. Dies kann aber dazu führen, dass die gewünschte Klebefläche nur noch teilweise mit der erforderlichen Klebstoffmenge benetzt ist, was zu deutlicher Verringerung der Fügequalität führt.

In der DE 37 39 333 A1wird ein Verfahren zur Herstellung von Schmelzklebeverbindungen beschrieben, in der ein Laser als Wärmequelle verwendet wird. Das Verfahren sieht vor, dass die zu verklebenden Wafer rückseitig in einer Lackschleuderanlage mit einer Schmelzkleberlösung bzw. mit einem Klebelack beschichtet oder mit einer Folienbügelanlage mittels einer Klebefolie kaschiert werden. Anschließend werden die Wafer wie üblich zersägt und die vereinzelten Chips getrocknet. Die Chips werden nun im Takt gleichzeitig vom Wafer abgehoben und paarig mit dem Laser fixiert. Die Energie des Laserstrahls dient hier zum Aufschmelzen des Klebstoffes, um die Fügung der Partner herzustellen.

Aufgabe der Erfindung ist es daher, ein verbessertes Verfahren zum Kleben von Mikrobauteilen auf ein Substrat zur Herstellung von Mikrosystembauelementen zu schaffen, das ein rationelles Fügen einer Vielzahl von Mikrobauteilen einzeln nacheinander oder vorzugsweise in einem Schritt ermöglicht und ein Verschieben der Mikrobauteile unter Berücksichtigung der hohen Genauigkeitsanforderungen in der Mikrosystemtechnik nach dem Aufbringen der Mikrobauteile auf das Substrat verhindert.

Diese Aufgabe wird mit dem Mikrosystembauelement nach Anspruch 1 und dem Verfahren nach Anspruch 4 gelöst. Als Schmelzklebstoff wird erfingdungsgemäß eine Dispersion eingesetzt. Die Dispersion kann beispielsweise im Siebdruck mit einem an ausgewählten Klebeflächen entsprechende Sieböffnungen aufweisenden (konturierten) Sieb aufgetragen werden.

Reaktive oder nicht reaktive Schmelzklebstoffe sind grundsätzlich aus der Makrotechnik bekannt. Im Unterschied zu den viskosen Klebstoffen erfolgt die Klebung beim Abkühlen sofort ohne Aushärtezeit, nachdem der Schmelzklebstoff über die Schmelztemperatur erwärmt wurde. In Abhängigkeit vom Schmelzklebstoff ist die Klebverbindung reversibel oder irreversibel. Bei reaktiven bzw. nahvernetzenden Schmelzklebstoffen ist die Klebverbindung nicht reversibel, sobald die Reaktion bzw. Nahvernetzung gestartet wurde. Bei einer reversiblen Klebverbindung kann das Mikrobauteil nach Erwärmen über eine spezifische Temperatur wieder abgelöst werden.
Allerdings ist sowohl bei der reversiblen, als auch bei der irreversiblen Klebverbindung ein Anhaften des Mikrobauteils an dem Substrat gewährleistet, bei dem das Mikrobauteil sich nicht mehr verschiebt, auch nicht um geringste Entfernungen im µm-Bereich.

Schmelzklebstoffe sind Klebstoffe, die durch Wärmeeinwirkung aufschmelzen und bei Erstarren die Klebverbindung bilden. Übliche Schmelzklebstoffe sind beispielsweise Mischungen von Ethylen-Vinylacetat-Copolymeren, Polyamiden oder gesättigten Polyestern mit Zusätzen wie Harzen, Weichmachern, Stabilisatoren oder Füllstoffen.

Im Unterschied hierzu sind Reaktionsklebstoffe zu sehen, die durch chemische Reaktion abbinden. Dabei stellt sich jedoch das oben genannte Problem der Topf- und Abbindezeit. Weiterhin sind anlösende Klebstoffe bekannt, die die zu verklebenden Oberflächen anlösen, so dass nach Diffusion der Makromoleküle und Verdunstung des Lösemittels die Klebung eintritt. Auch hier ist die Reaktionszeit zu lang. Alles-Kleber binden ebenfalls durch Verdunsten von Lösungsmittel ab.

Die reaktiven oder nicht reaktiven Schmelzklebstoffe sind auch im Unterschied zu herkömmlichen Haftklebstoffen zu sehen, die als dauerklebrige Klebstoffe zumeist auf Kautschukbasis bei geringem Druck haften, bei dauernder Last jedoch zum Kriechen neigen. Ungeeignet sind auch Kontaktklebstoffe, die auf beide zu verklebenden Oberflächen aufgetragen werden müssen, wobei nach einer Vortrocknung die Klebung durch kurzzeitiges, starkes Zusammendrücken erfolgt.

Reaktive oder nicht reaktive Schmelzklebstoffe zeichnen sich als physikalisch abbindende Klebstoffe dadurch aus, dass ein einseitiges Auftragen und Anliegen der Klebflächen zur Herstellung einer Klebverbindung ausreicht, wobei ein Wärmeeintrag vor oder nach dem Auftragen erfolgt. Die Aushärtung erfolgt durch Abkühlung, so dass die Aushärtezeit beliebig klein eingestellt werden kann und so ein Verschieben der Mikrobauteile auf dem Substrat während der Klebung verhindert wird.

Schmelzklebstoffe haben zudem den Vorteil, dass die Klebverbindung reversibel ist, durch ein Nachhärteprozess jedoch auch irreversibel gemacht werden kann.

Nach dem Aufkleben des mindestens einen Mikrobauteils auf das Substrat wird vorzugsweise eine Nacherwärmung des Systembauelementes durchgeführt, um eine Verklebung zu erreichen. Die Nacherwärmung kann hierbei selektiv beispielsweise mittels Laser oder global erfolgen.

Die Aufgabe wird weiterhin durch das Mikrosystembauelement gelöst, bei dem die Klebverbindung zwischen Substrat und Mikrobauteilen mit einer Schmelzklebstoff-Dispersion ausgeführt ist. Dabei sind die Mikrobauteile vorzugsweise kleiner als 1000 µm

Die Erfindung wird nachfolgend anhand der beigefügten Zeichnungen näher erläutert. Es zeigen:
- Figur 1 -: Skizze eines Verfahrens zum Auftragen von dispergiertem Schmelzklebstoff mit Hilfe einer Walze;
- Figur 2 -: Skizze eines Verfahrens zum Auftragen von Klebstoff auf ausgewählte Klebestellen durch Eintauchen einer erhabenen Struktur in eine Dispersion;
- Figur 3 -: Skizze eines Verfahrens zum Auftragen von Klebstoff mittels Siebdruck;
- Figur 4 -: Skizze eines Verfahrens zum Auftragen eines Klebstoffs mit Hilfe eines Transferbandes oder einer aus Schmelzklebstoff hergestellten Folie;
- Figur 5 -: Skizze eines Verfahrens zum Auftragen von Klebstoff mit einem Transferband für konturierte Schmelzklebstoffe;
- Figur 6 -: Skizze des Verfahrens zum Auftragen von Klebstoff auf eine Transferfolie oder einem Substrat, wobei konturierte Klebststoffabschnitte auf die Transferfolie oder dem Substrat abgelegt werden;
- Figur 7 -: Skizze des Verfahrens zum Auftragen eines Klebstoffs durch Eintauchen eines Mikrobauteils in eine Dispersion.

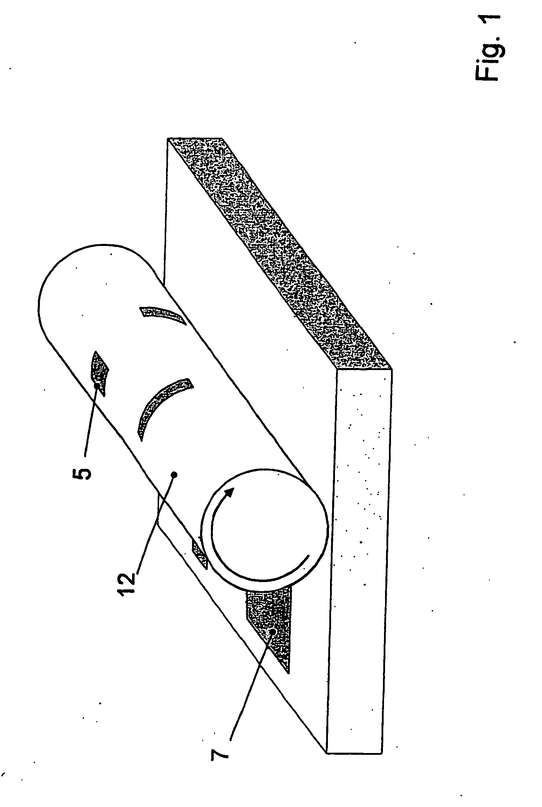

Die Figur 1 lässt eine Ausführungsform des Verfahrens zum Kleben von Mikrobauteilen auf ein Substrat 1 erkennen. Das Verfahren sieht das Auftragen eines Klebstoffs 5 in Form einer Dispersion eines Schmelzklebstoffs vor. Der Klebstoff 5 wird dabei auf eine elektrostatisch geladene oder konturierte Walze 12 aufgebracht, die relativ zu der Oberfläche des Substrates 1 bewegt wird. Hierdurch wird der gezielt lokal auf der Oberfläche der Walze 12 haftende Klebstoff 5 auf die ausgewählten Klebflächen 7 transferiert.

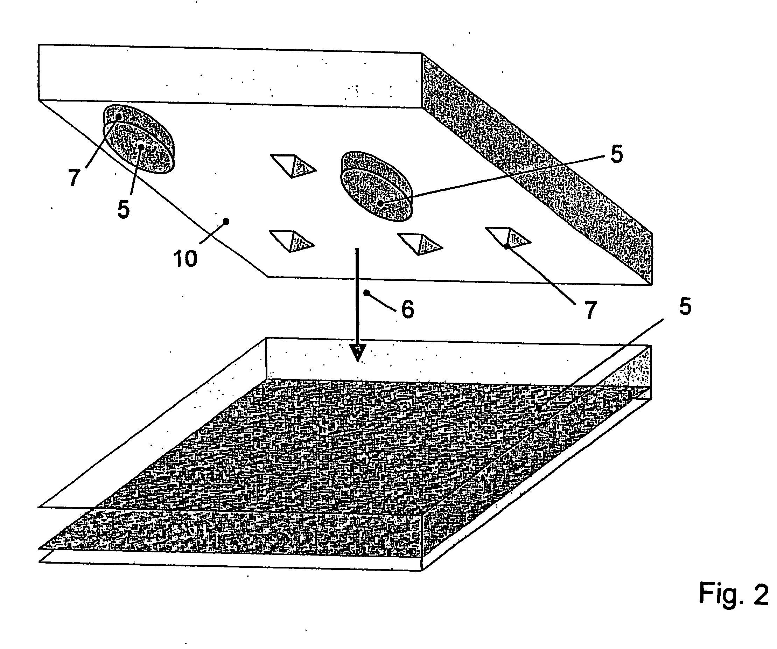

Die Figur 2 lässt eine andere Ausführungsform des Verfahrens zum Auftragen eines Klebstoffs 5 auf ausgewählte Klebstellen eines Substrates 1 oder Mikrobauteils erkennen. Das Substrat 1 oder Mikrobauteil hat an den ausgewählten Klebeflächen 7 eine erhabene Struktur, die in eine Dispersion eines Schmelzklebstoffs eingetaucht wird. Die erhabenen Klebflächen 7 werden auf dieser Weise mit Klebstoff 5 benetzt und die nicht zu klebenden Flächen 10 des Substrates 1 bleiben unbeschichtet.

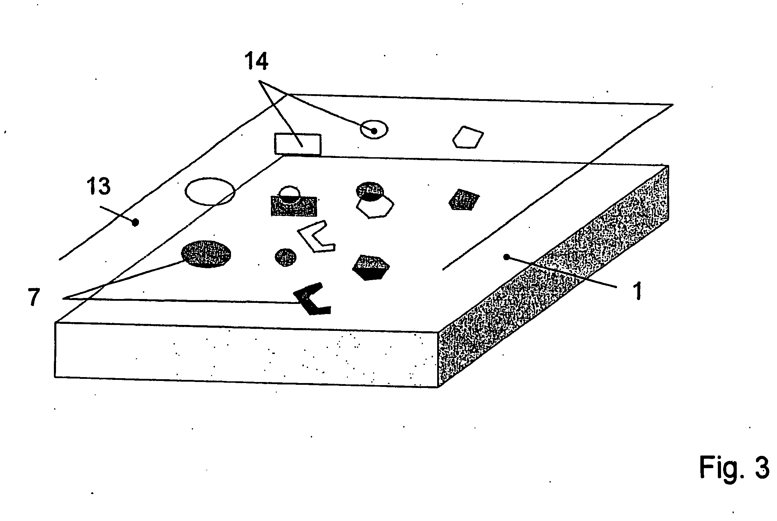

Die Figur 3 lässt eine andere Ausführungsform zum Auftragen von Klebstoff 5 in Form einer Dispersion eines solchen Klebstoffs 5 erkennen. Der Klebstoff 5 wird hierbei durch ein konturiertes Sieb gestreut oder mit Hilfe eines Siebdruckverfahren als Dispersion mit Hilfe eines Siebes 13, das den ausgewählten Klebeflächen 7 entsprechende Sieböffnungen 14 hat, aufgetragen.

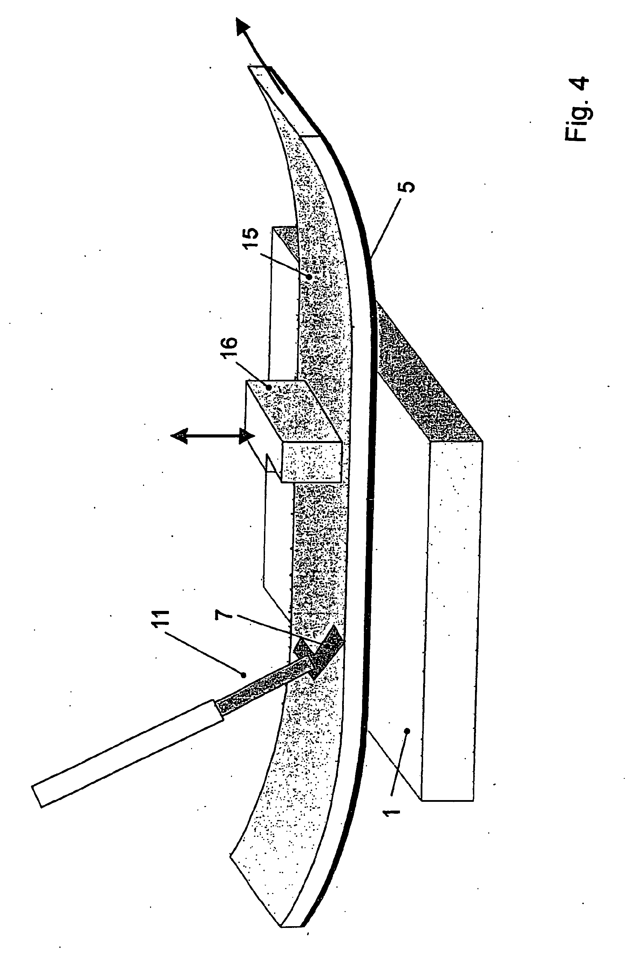

Die Figuren 4 bis 6 lassen eine andere Methode zum Auftragen von Klebstoff 5 auf ein Substrat 1 oder Mikrobauteil mit Hilfe einer Transferfolie 15 erkennen. Die Transferfolie 15 kann ähnlich wie ein Schreibmaschinenband über die Oberfläche des Substrates 1 bewegt werden. Die Transferfolie 15 trägt auf der Oberfläche, die dem Substrat 1 zugewandt ist, den Schmelzklebstoff 5 als relativ dünne Schicht. Mit Hilfe einer fokussierten Wärmequelle 11, beispielsweise eines Lasers, wird die Folie an ausgewählten Stellen, die den Klebflächen 7 entsprechen, erwärmt und auf diese Weise der Klebstoff 5 auf die Oberfläche des Substrates 1 an den ausgewählten Klebstellen 7 angeheftet. Alternativ kann mit Hilfe eines konturierten Stempels 16 der Klebstoff 5 an den ausgewählten Klebstellen 5 mechanisch auf die Oberfläche des Substrates 1 aufgedrückt werden. Die transferbandartige Folie 15 wird, wie durch den Pfeil skizziert, kontinuierlich oder diskontinuierlich relativ zur Oberfläche des Substrates 1 bewegt, so dass immer vollständige Klebstoffflächen zum Auftragen auf das Substrat 1 verfügbar sind.

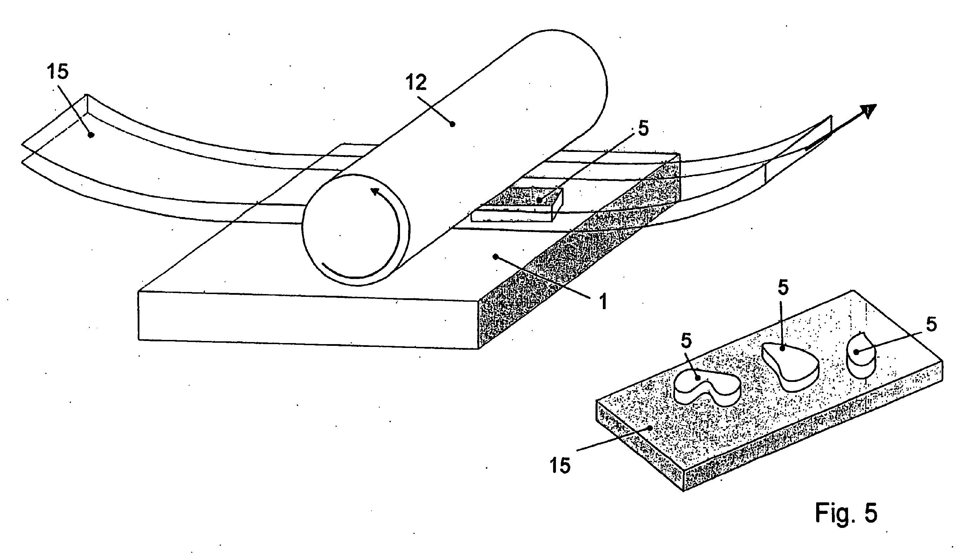

Die Figur 5 lässt eine anderen Ausführungsform des Aufbringens von Klebstoff 5 mit Hilfe einer Transferfolie 15 auf ein Substrat 1 und ein Mikrobauteil erkennen. Der Klebstoff 5 ist hierbei bereits in den Klebflächen 7 in entsprechender konturierter Form auf die Transferfolie 15 aufgetragen. Das Konturieren kann durch Ausschneiden beispielsweise mittels Laser oder Fräser erfolgen. Die Transferfolie 15 mit dem konturierten Klebstoff 5 wird dann auf die Oberfläche des Substrates 1 gelegt und mit einer Walze 12 angedrückt, so dass der Klebstoff 5 auf der Oberfläche des Substrates 1 haften bleibt.

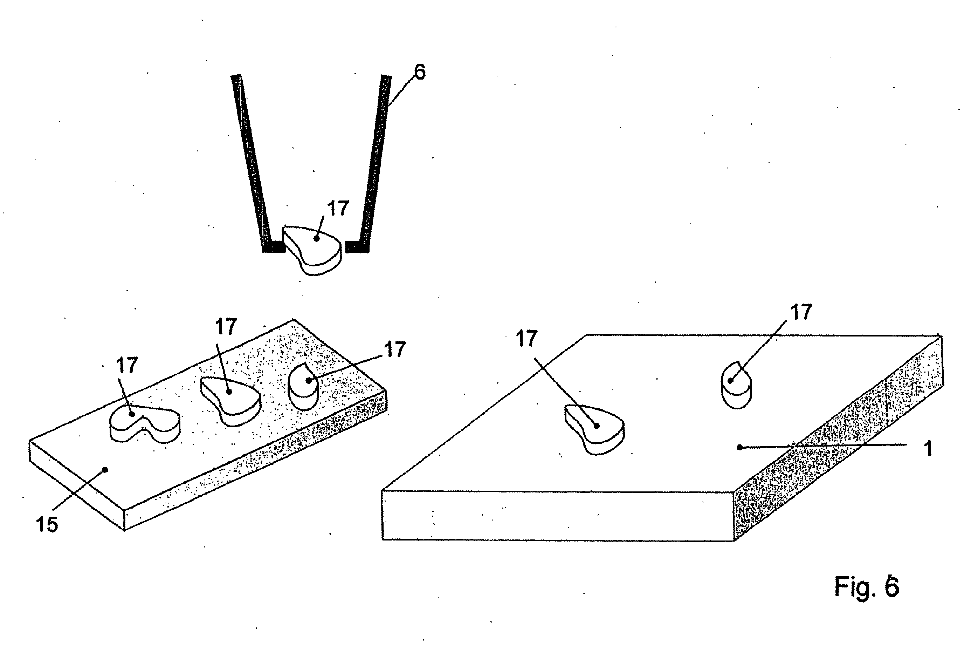

Die Figur 6 lässt eine andere Ausführungsform erkennen, bei der eine konturierte Klebstofffolie 17 mit einem Greifer 6 aufgegriffen und auf eine Transferfolie 15 gezielt abgelegt wird. Die Transferfolie 15 kann dann wie in der Figur 10 gezeigt auf das Substrat 1 aufgebracht werden. Die konturierte Klebstofffolie 17 kann aber auch, wie in der Figur 11 skizziert, unmittelbar auf das Substrat 1 an den ausgewählten Klebflächen 7 abgelegt werden.

Der Greifer 6 kann ein Sauggreifer, ein elektrostatisch geladener Greifer oder ein mechanischer Greifer, eine Nadel etc. sein.

Der Klebstoff 5 kann nicht nur auf die Oberfläche des Substrates 1, wie skizziert, sondern in entsprechender Weise auf die Mikrobauteile oder sowohl auf das Substrat 1 und die Mikrobauteile aufgetragen werden.

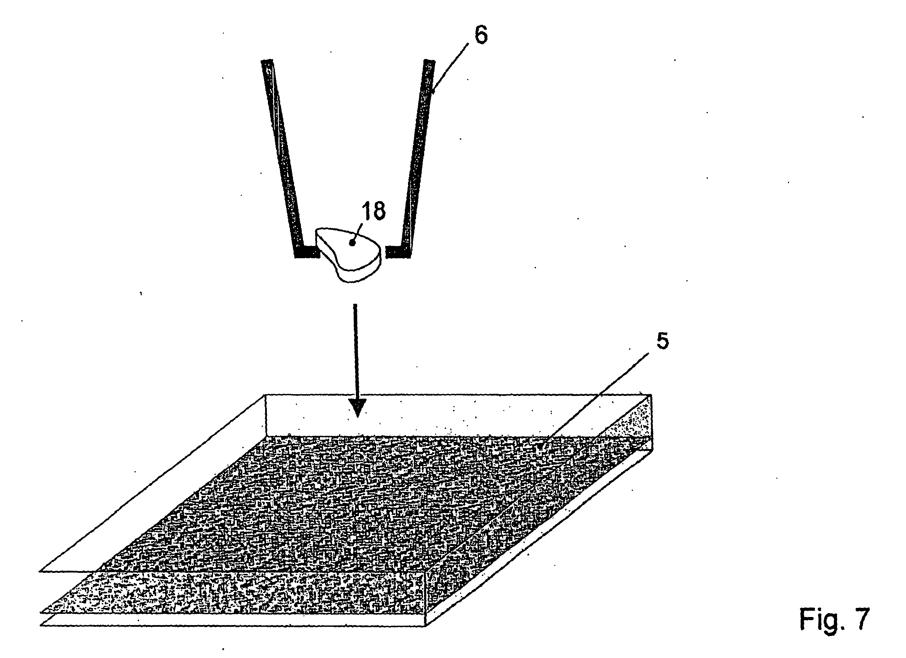

Hierbei kann, wie in der Figur 7 skizziert, das Mikrobauteil 18 mit einem Greifer 6 ergriffen und in ein Gefäß mit einer Dispersion eines Schmelzklebstoffs eingetaucht werden. Vorteilhaft ist es, wenn dabei das Mikrobauteil 18 erwärmt ist.

## Patentansprüche

1. Mikrosystembauelement mit mindestens einem auf ein Substrat (1) geklebtes Mikrobauteil (18), **dadurch gekennzeichnet, dass** die Klebeverbindung mit einer Dispersion eines Schmelzklebstoffs (5) ausgeführt ist durch
- Auftragen einer Dispersion eines reaktiven oder nicht reaktiven Schmelzklebstoffs (5) auf die Oberfläche des Mikrobauteils (18) und/oder des Substrats (1);
- Erwärmen des Schmelzklebstoffs (5);
- Aufbringen des mindestens eines Mikrobauteils (18) auf das Substrat (1), wobei der Schmelzklebstoff (5) auf den Kontaktflächen zwischen Mikrobauteil (18) und Substrat (1) ist; und
- Aufkleben des mindestens einen Mikrobauteils (18) auf das Substrat (1) durch Anschmelzen des Schmelzklebstoffs (5).

2. Mikrosystembauelement nach Anspruch 1, **dadurch gekennzeichnet, dass** die Mikrobauteile (18) kleiner als 1.000 µm sind.

3. Mikrosystembauelement nach Anspruch 1 oder 2, **dadurch gekennzeichnet, dass** die Dispersion im Siebdruck mit einem an ausgewählten Klebeflächen (7) entsprechende Sieböffnungen (14) aufweisenden Sieb (13) aufgetragen ist.

4. Verfahren zum Kleben von Mikrobauteilen (18) auf ein Substrat (1) bei der Herstellung von Mikrosystembauelementen, **gekennzeichnet durch** die Schritte:
- Auftragen einer Dispersion eines reaktiven oder nicht reaktiven Schmelzklebstoffs (5) auf die Oberfläche des Mikrobauteils (18) und/oder des Substrats (1);
- Erwärmen des Schmelzklebstoffs (5);
- Aufbringen des mindestens eines Mikrobauteils (18) auf das Substrat (1), wobei der Schmelzklebstoff (5) auf den Kontaktflächen zwischen Mikrobauteil (18) und Substrat (1) ist; und
- Aufkleben des mindestens einen Mikrobauteils (18) auf das Substrat (1) durch Anschmelzen des Schmelzklebstoffs (5).

5. Verfahren nach Anspruch 4, **gekennzeichnet durch** Aufbringen von pulverförmigen Schmelzklebstoff **durch** ein konturiertes Sieb (13) auf das Substrat (1) oder Mikrobauteil (18).

## Claims

1. Microsystem component having at least one microcomponent (18) bonded to a substrate (1) **characterised in that** the adhesive bonding is performed by a dispersion of the hotmelt adhesive (5) by
- applying the dispersion of a reactive or nonreactive hotmelt adhesive (5) to the surface of the microcomponent (18) and/or the substrate (1);
- heating the hotmelt adhesive (5);
- applying the at least one microcomponent (18) to the substrate (1), the hotmelt adhesive (5) being on the contact areas between microcomponent (18) and substrate (1); and
- adhesion of the at least one microcomponent (18) to the substrate (1) by incipient melting the hotmelt adhesive (5).

2. Microsystem component according to claim 1, **characterised in that** the microcomponents (18) are smaller than 1,000 µm.

3. Microsystem component according to claim 1 or 2, **characterised in that** the dispersion is applied by means of a screen printing technique using a screen (13) that has screen openings (14) corresponding to the selected bond areas (7).

4. Method for gluing microcomponents (18) to a substrate (1) in the production of microsystem components, **characterised by** the steps:
- applying a dispersion of a reactive or nonreactive hotmelt adhesive (5) to the surface of the microcomponent (18) and/or the substrate (1);
- heating the hotmelt adhesive (5);
- applying the at least one microcomponent (18) to the substrate (1) the hotmelt adhesive (5) being on the contact areas between microcomponent (18) and substrate (1); and
- adhesion of the at least one microcomponent (18) to the substrate (1) by incipient melting the hotmelt adhesive (5).

5. Method according to claim 4, **characterised by** applying a pulverulent hotmelt adhesive through a contoured screen (13) to the substrate (1) or the microcomponent (18).

## Revendications

1. Composant de microsystème comprenant au moins un microcomposant (18) collé sur un substrat (1), **caractérisé en ce que** l'assemblage collé est effectuée au moyen d'une dispersion d'une colle fusible (5) par
- application d'une dispersion d'une colle fusible (5) réactive ou non réactive, sur la surface active du microcomposant (18) et/ou du substrat (1);
- chauffage de la colle fusible (5) ;
- apport de l'au moins un microcomposant (18) sur le substrat (1), la colle fusible (5) étant sur les surfaces de contact entre microcomposant (18) et substrat (1) ; et
- collage de l'au moins un microcomposant (18) sur le substrat (1) par fonte de la colle fusible (5).

2. Composant de microsystème selon la revendication 1, **caractérisé en ce que** les microcomposants (18) sont inférieurs à 1.000 µm.

3. Composant de microsystème selon la revendication 1 ou 2, **caractérisé en ce que** la dispersion est appliquée dans la sérigraphie à l'aide d'un tamis (13) présentant des ouvertures de tamis (14) correspondantes sur des surfaces de collage (7) choisies.

4. Procédé pour coller des microcomposants (18) sur un substrat (1) lors de la fabrication de composants de microsystème, **caractérisé par** les étapes suivantes :
- application d'une dispersion d'une colle fusible (5) réactive ou non réactive, sur la surface active du microcomposant (18) et/ou du substrat (1);
- chauffage de la colle fusible (5)
- apport de l'au moins un microcomposant (18) sur le substrat (1), la colle fusible (5) étant sur les surfaces de contact entre microcomposant (18) et substrat (1) ; et
- collage de l'au moins un microcomposant (18) sur le substrat (1) par fonte de la colle fusible (5).

5. Procédé selon la revendication 4, **caractérisé par** l'apport de colle fusible poudreuse à travers un tamis (13) à contour défini sur le substrat (1) ou microcomposant (18).
